(19) Europäisches Patentamt
European Patent Office
Office européen des brevets

(11) **EP 4 119 938 A1**

(12) **EUROPEAN PATENT APPLICATION**

(43) Date of publication:
**18.01.2023 Bulletin 2023/03**

(21) Application number: **21305970.2**

(22) Date of filing: **12.07.2021**

(51) International Patent Classification (IPC):
**G01N 27/82** (2006.01)    **G01N 27/83** (2006.01)
**G01R 33/26** (2006.01)

(52) Cooperative Patent Classification (CPC):
**G01N 27/82; G01N 27/83; G01R 33/26;**
G01R 33/323

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Wainvam-E
56270 Ploemeur (FR)**

(72) Inventors:
• **GEIGER, Remi
56530 Quéven (FR)**
• **BEATO, François
56100 Lorient (FR)**
• **GUITTON, Gabrielle
56260 Larmor-plage (FR)**

(74) Representative: **Novagraaf Technologies
Bâtiment O2
2, rue Sarah Bernhardt
CS90017
92665 Asnières-sur-Seine Cedex (FR)**

(54) **SENSOR HEAD AND MEASURING DEVICE INCLUDING SAID SENSOR HEAD**

(57)    An object of the present disclosure is a sensor head (A) comprising:
an array of a plurality of point defect doped diamond crystals (1103, 1202) ;
a plurality of optical fibers (52, 1107), a first end of each fiber being optically coupled to a respective crystal (41) ;
at least one magnet (45, 1205, 1301) for providing a bias magnetic field to the crystals;
at least one resonator (44) for providing a microwave magnetic field to said crystals;
a substrate (1101, 1201) having a front side for facing an item (71) to be analyzed using said array and a back side opposite to the front side;
a second end of each fiber being adapted to receive excitation light (42) for exciting the respective crystal and to transmit a fluorescence light generated by the respective crystal (41);
wherein said array of crystals is positioned with regard to said substrate to be able to face said item, each optical fiber being positioned to illuminate the respective crystal from the back side of the substrate towards the front side.
    Another object is a measuring device comprising a sensor head.

**FIG. 8**

**Description**

TECHNICAL FIELD

A sensor head based on point defect diamond crystals, for example nitrogen-vacancy diamond crystals, as well as a measuring device including such a head are described. These can be used to measure magnetic fields and other physical parameters in a variety of applications including but not limited to non-destructive testing.

BACKGROUND

Non-destructive testing (NDT) is an important application in many fields, for example for determining the inner structure and possible defects of a material such as steel. A sample to be tested, e.g. a steel bar, is submitted to alternating magnetic fields in order to induce eddy currents. The induced currents generate auxiliary magnetic fields that can be measured using a magnetic sensor also called magnetometer. These induced currents - and hence the auxiliary magnetic fields - depend on the physical properties of the tested sample. These physical properties comprise electrical conductivity, magnetic permeability, thickness... and depend on turn on the local properties of the material of the sample (e.g. the local presence of corrosion, impurities or cavities within the sample) and on the frequency of the alternating magnetic field used for excitation. A good spatial resolution is generally desirable, e.g. for eddy current based NDT, a resolution of less than 1mm can be necessary in order to adequately perform defect detection.

Arrays of magnetic sensors include arrays of coil-based magnetometers, arrays of Hall effect probes and arrays of magnetoresistive sensors (anisotropic magnetoresistive (AMR) sensors, giant magnetoresistive (GMR) sensors, tunnel magnetoresistive (TMR) sensors). Reaching a high spatial resolution requires a small sensor size (i.e. size of the elementary sensor composing the array). Depending on the applications, a small lift-off distance (distance between the surface of the material under test and the sensing probe) can also be desirable. Depending on the applications, a lift-off distance of less than one mm may be desirable.

These different sensor technologies are adapted to different frequency bands with regard to the exciting magnetic field, ranging from low frequencies (e.g. sub-Hz) to high frequencies (in the GHz range). For the above technologies, the performance with regard to noise generally decreases for lower frequencies. On the other hand, certain applications, in particular those involving magnetic materials, may require testing at low frequencies (typically ranging from a few Hz to a few kHz), where these sensor technologies are inefficient. This applies for example for materials with a magnetic permeability $\mu_r$ larger than about 10, which is the case for certain types of steel. NDT of such materials with good spatial resolution is a challenge since it requires small sensors with low enough noise at low frequencies.

Atom-based magnetic sensors, which measure atomic energy level differences that are linked to the magnetic field (often in a proportional relationship) show improved noise performance when targeting low frequencies (0 Hz to sub-kHz), compared to the above-mentioned technologies (coils, Hall probes, magneto-resistive sensors). However, atom-based magnetic sensors are of relatively large size. Reaching a good compromise between the size of the sensor and its self-noise at low frequencies is a challenge.

Magnetometers based on the probing of the energy level differences in Nitrogen Vacancy (NV) color centers in diamonds are a promising technology for NDT. Micron-scale resolution has been demonstrated in so-called wide-field magnetic imaging schemes where a crystal of NV diamond is imaged by a microscope objective. However, the wide-field NV microscope solution is not suited for industrial applications such as imaging of defects of steel bars in production or imaging of material defects in e.g. oil-and-gas casing, due to the presence of a microscope objective that requires a precise and stable alignment with the diamond crystal. Other examples of applications of NDT in which microscope objectives may be at a disadvantage include aeronautics, nuclear power plants, underground and underwater pipes, etc...

A Nitrogen Vacancy diamond-based sensor using a microscope objective is described in US patent 10,962,610. A Nitrogen Vacancy diamond-based sensor using an optical fiber is described in 'Simultaneous thermometry and magnetometry using a fiber-coupled quantum diamond sensor' Hatano et al., AIP Publishing, Applied Physics Letter 118, 034001 (2021). Another Nitrogen Vacancy diamond-based sensor using an optical fiber is described in 'Imaging Damage in Steel Using A Diamond Magnetometer' - by L.Q. Zhou et al., in Physical Review Applied 15, 024015 (2021), published by the American Physical Society.

SUMMARY

The scope of protection is set out by the independent claims. The embodiments, examples and features, if any, described in this specification that do not fall under the scope of the protection are to be interpreted as examples useful for understanding the various embodiments or examples that do fall under the scope of protection.

One or more exemplary embodiments concern a sensor head comprising:

an array of a plurality of point defect doped diamond crystals;

a plurality of optical fibers, a first end of each fiber being optically coupled to a respective crystal;

at least one magnet for providing a bias magnetic field to the crystals;

at least one resonator for providing a microwave magnetic field to said crystals;

a substrate having a front side for facing an item to be analyzed using said array and a back side opposite to the front side;

a second end of each fiber being adapted to receive excitation light for exciting the respective crystal and to transmit a fluorescence light generated by the respective crystal;

wherein said array of crystals is positioned with regard to said substrate to be able to face said item, each optical fiber being positioned to illuminate the respective crystal from the back side of the substrate towards the front side.

According to one embodiment, each of said crystals protrudes from said front side of the substrate.

According to one embodiment, said at least one resonator is a flat resonator, printed on said front side of the substrate or the back side of the substrate.

According to one embodiment, there is a single common resonator for providing a microwave magnetic field to all diamond crystals of the plurality of diamond crystals.

According to one embodiment, said single common resonator is a ring resonator, said array being placed within the perimeter of a ring of the ring resonator.

According to one embodiment, the sensor head comprises an electric conductor adapted to provide a microwave signal from a microwave source to said resonator.

According to one embodiment, the sensor head comprises a respective individual resonator for each crystal of the array.

According to one embodiment, said respective resonator is a ring resonator, wherein a crystal is placed within a ring of its respective resonator.

According to one embodiment, the sensor head comprises a respective electric conductor adapted to provide a microwave signal from a respective microwave source to a respective individual resonator.

According to one embodiment, said diamond crystals and said substrate are covered with a protective coating to achieve a flat sensor head surface on said front side. One advantage of having a flat sensor surface is allow the sensor to slide along the object to be tested. The fact of covering the diamond crystals with a coating also protects the sensor head.

According to one embodiment, said at least one magnet comprises

- an individual permanent magnet for each crystal in the array, wherein each individual magnet is threaded on an optical fiber coupled to its respective crystal; or
- an individual coil each crystal in the array, wherein each individual coil is threaded on an optical fiber coupled to its respective crystal.

According to one embodiment, said at least one magnet comprises as single permanent magnet for all crystals in the array, wherein said single magnet is drilled with a plurality of respective holes, each hole being configured to let one fiber pass.

According to one embodiment, said point defect is one of a Nitrogen Vacancy, NV, a Silicon Vacancy, SiV, or Germanium Vacancy, GeV, point defect.

One or more exemplary embodiments concern a measuring device comprising a sensor head as indicated above and further comprising:

- at least one microwave source for providing a respective microwave signal to each of said at least one resonators;
- at least one source of excitation light for providing a respective excitation light to each diamond crystal through a respective fiber;
- a respective photodiode for each of said plurality of diamond crystals, a respective photodiode being optically coupled to receive, by a separator adapted to filter out excitation light, a fluorescence generated by a respective diamond crystal through a respective optical fiber, and for generating a respective signal in response to said fluorescence;
- at least one amplifier for amplifying respective signals from said photodiodes for providing respective amplified signals;
- a processor for processing said respective amplified signals provided by said amplifier and for generating a signal representative of an image representative of an item being analyzed by said sensor head.

According to an embodiment, when said sensor head comprises an individual resonator for each diamond crystal, the measuring device comprises a respective individually controllable microwave source for each individual resonator.

## BRIEF DESCRIPTION OF THE DRAWINGS

Example embodiments will be more fully understood from the detailed description provided herein and the accompanying drawings, which are given by way of illustration only.

FIG. 1 is a schematic representation of a diamond crystal and its carbon atoms (C), and comprising a nitrogen atom (N) and a vacancy (V), the latter two forming an 'NV center';

FIG. 2 is a schematic diagram of the energy levels of an NV center;

FIG. 3 is a graph of ODMR (Optically Detected Magnetic Resonance) data obtained by measuring the red fluorescence for different magnetic field values;

FIG. 4 is a block diagram of the components of a subsystem for a single pixel of the NV magnetometer array;

FIG. 5 is a graph representing a signal provided by a photodiode, as well as the demodulated signal provided by a lock-in amplifier according to a non-limiting embodiment;

FIG. 6 is a schematic diagram that shows an optical fiber regarding certain elements of a subset of elements from FIG. 4 and showing how they relate to an individual optical fiber;

FIG. 7 is a schematic diagram representing a side view of one extremity of the submodule corresponding to a single pixel of a sensor array according to a non-limiting embodiment;

FIG. 8 is a schematic diagram representing a side view of five aligned submodules each corresponding to a single pixel of the array according to a non-limiting embodiment;

FIG. 9 is a schematic diagram of one possible embodiment of a double-ring microwave resonator;

FIG. 10 represents a simulation of the microwave magnetic field for the double-ring microwave resonator of FIG. 9;

FIG. 11a is a three-dimensional rendering of a first embodiment of a sensor module, using a common double-ring microwave resonator;

FIG. 11b is a sectional side view of the sensor module of FIG. 11a;

FIG. 11c is a front view of the sensor module of FIG. 11a;

FIG. 12a is a three-dimensional rendering of a second embodiment of a sensor module, using individual microwave resonators and a common bias magnet;

FIG. 12b is a sectional side view of the sensor module of FIG. 12a;

FIG. 12c is a front view of the sensor module of FIG. 12a;

FIG. 13a is a three-dimensional rendering of a third embodiment of a sensor module, using individual microwave resonators and individual bias magnets;

FIG. 13b is a sectional side view of the sensor module of FIG. 13b.

It should be noted that these figures are intended to illustrate the general characteristics of methods, structure and/or materials utilized in certain example embodiments and to supplement the written description provided below. These drawings are not, however, to scale and may not precisely reflect the exact structural or performance characteristics of any given embodiment. They should not be interpreted as defining or limiting the range of values or properties encompassed by example embodiments. The use of similar or identical reference numbers in the various drawings is intended to indicate the presence of a similar or identical element or feature.

## DETAILED DESCRIPTION

Various exemplary embodiments will now be described more fully with reference to the accompanying drawings. However, specific structural and functional details disclosed herein are merely representative for purposes of describing example embodiments. The exemplary embodiments may be embodied in many alternate forms and should not be construed as limited to only the embodiments set forth herein. It should be understood that there is no intent to limit example embodiments to the particular forms disclosed.

It should be appreciated by those skilled in the art that any functions, engines, block diagrams, flow diagrams, state transition diagrams and / or flowcharts herein represent conceptual views of illustrative circuitry embodying the principles of the exemplary embodiments. Each described function, engine, block, step can be implemented in hardware, software, firmware, middleware, microcode, or any suitable combination thereof. If implemented in software, the functions, engines, blocks of the block diagrams and/or flowchart illustrations can be implemented by computer program instructions / software code, which may be stored or transmitted over a computer-readable medium, or loaded onto a general purpose computer, special purpose computer or other programmable processing apparatus and / or system to produce a machine, such that the computer program instructions or software code which execute on the computer or other programmable processing apparatus, create the means for implementing the functions described herein.

In the present description, functional blocks denoted as "means configured to perform ..." a certain function shall be understood as functional blocks comprising circuitry that is adapted for performing or configured to perform a certain function. A means being configured to perform a certain function does, hence, not imply that such means necessarily is performing said function (at a given time instant). Moreover, any entity described herein as "means", may correspond to or be implemented as "one or more modules", "one or more devices", "one or more units", etc. When provided by a processor, the functions may be provided by a single processor or several processors. Moreover, the term "processor" or "controller" may implicitly include one or more of a digital signal processor (DSP) hardware, network processor, application specific integrated circuit (ASIC), field programmable gate array (FPGA), Graphical Processing Unit (GPU), read only memory (ROM) for storing software, random access memory (RAM), and non-volatile storage. Other hardware, conventional or custom, may also be included.

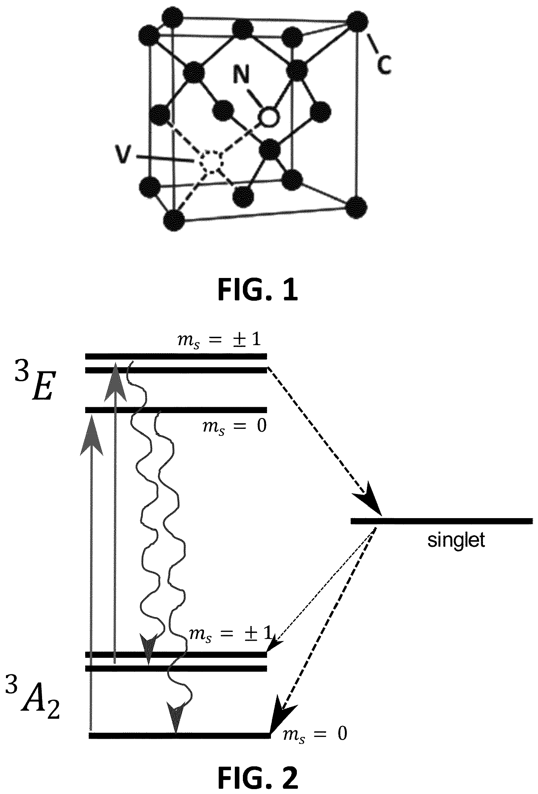

NV magnetometry is based on the use of a particular defect of the diamond crystal lattice in the solid state. The term NV (Nitrogen-Vacancy) center refers to the substitution of a carbon atom by a nitrogen atom, directly adjacent to an atomic gap (a missing carbon atom), as shown in FIG. 1. This defect presents an energetic structure and various interesting physical characteristics, which can be used in a magnetic field sensor. These measurements can also be used to determine temperatures, electric fields, strains and pressure. In particular, when a NV diamond crystal (containing millions of NV centers) is irradiated with green light (e.g. coming from a laser or a LED), it fluoresces red light with an intensity proportional to the irradiation.

FIG. 2 is a schematic diagram of the energy levels of the NV center, and showing the ground state triplet state $^3A_2$, the excited triplet state $^3E$ and the singlet state. Owing to quantum mechanical selection rules, when the NV center is in the $m_s = 0$, respectively $m_s = \pm 1$ state, in the ground state, it tends to stay in the $m_s = 0$, respectively $m_s = \pm 1$, state when absorbing a green photon from the excitation light source, as shown by the two upward oriented straight arrows. Similar selection rules apply when the NV center is deexcited from the excited state to the ground state by the emission of a red fluorescence photon, as shown by the two downward oriented wobbly arrows. However, when the NV center lands in the $m_s = \pm 1$ levels in the excited state, it has a larger (about 7 times) probability to decay non radiatively in the singlet state than when in the $m_s = 0$ excited state. From the singlet state, the NV center returns preferentially (with a two times larger probability) to the $m_s = 0$ ground state. As a result, the NV center can be optically polarized in the $m_s = 0$ ground state through the application of green excitation light. Red fluorescence is emitted owing to the radiative decay from the excited state to the ground state. This level of fluorescence varies depending on the initial spin level of the NV center in the ground state: more fluorescence is recorded when the NV center is initially in the $m_s = 0$ spin level than in the $m_s = \pm 1$ levels, owing to the non-radiative transitions through the singlet state in the second case.

A microwave field with a frequency around 2.87 GHz can be applied to change the spin state of the NV center in its ground state from $m_s = 0$ to $m_s = 1$ or $m_s = -1$. When the frequency of the microwave field is resonant with the energy level difference, less red fluorescence is observed. This phenomenon is called Optically Detected Magnetic Resonance ('ODMR').

A magnetic field lifts the degeneracy between the $m_s = 1$ and $m_s = -1$ levels. Therefore, when a magnetic field is applied to the NV center, two frequencies for which the fluorescence decreases can be observed, linearly related to the magnitude of the magnetic field:

$$f_{res} = 2.87\,\text{GHz} \pm \frac{\gamma}{2\pi} B \qquad (\text{Eq.1})$$

where B is the magnetic field aligned with the axis of the NV center (i.e. the axis defined by the alignment of the nitrogen atom and the gap) and $\gamma$ is the gyromagnetic ratio of the NV center: $\gamma/2\pi = 28$ GHz/T.

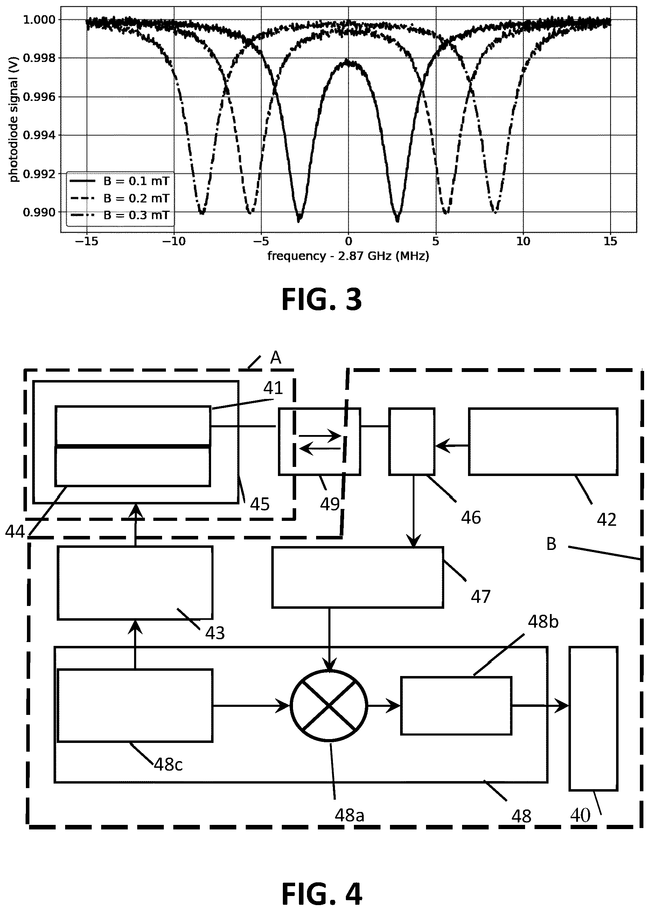

FIG. 3 is a graph of simulated ODMR data that can be obtained by measuring the red fluorescence for different magnetic field values. For each value of the magnetic field, the two resonance dips in the photodiode output signal and centered around the excitation frequency appear clearly. Since the NV centers can exist in four different directions within the crystal, a total of four pairs of two resonances can actually be observed, each pair corresponding to a projection of the magnetic field vector onto a given direction of an NV axis. This allows to univocally identify the three spatial components of the magnetic field, and thus to obtain a vector measurement of the latter.

The NV sensor allows an accurate vector measurement of a magnetic field, with a good sensitivity: the latter is basically limited by the photon shot noise of the fluorescence light, reaching typical values ranging from pT/$\sqrt{}$ Hz to nT/$\sqrt{}$ Hz depending on the sensor design.

According to an embodiment, it is proposed to arrange several point-like NV magnetometers in an array configuration. This allows avoiding the technical complexity of an NV microscope, i.e. an NV magnetometer using a microscope objective, while achieving a good spatial resolution.

According to the embodiment, the array comprises MxN NV diamonds (with M and N integers, with at least one of M and N being greater than 1) which are located close to one another, each diamond being connected to an optical fiber. The role of the optical fiber is to allow excitation of the corresponding diamond with green light and to collect the red fluorescence emitted by the NV centers in each diamond. The bundle of optical fibers collects the signals of interest and transmits them to a processing unit which analyses the respective fluorescence signals and determines the local magnetic fields from the electron spin resonance signals associated with each diamond of the array. The optical fibers allow the optical initialization and readout of the electronic spin state of the NV color centers in each diamond.

A fiber-based NV magnetometer array configuration allows separation of the sensing module per se of the device (i.e. the array of NV diamonds) from other modules of the device (e.g. the green light source, red fluorescence readout module and system control module). Depending on the application, the desired distance between the sensing module and the other modules can be obtained by using an appropriate length for the optical fibers. The length of the optical fibers may reach up to several hundreds of meters, noting that the longer the fibers, the higher the attenuation of the green excitation light and of the red fluorescence. A length of one meter may be useful for many applications, but this value is given solely as an example and shorter lengths may be selected depending on the application. E.g. shorter lengths may range from a few centimeters to a few meters. The configuration allows use of the array of sensors in close proximity (e.g. 1 mm or less) to the sample under test in order to improve the signal associated with a potential defect in the material, without having to take into account possible issues due to the close proximity of part or all of the other modules either with regard to the sample and/or with regard to the sensing module, as will be explained in more detail later.

FIG. 4 is a block diagram of the components of a subsystem for a single pixel of the NV magnetometer array according to an embodiment. Some of the components - for example but not limited to the bias magnet, the green light excitation source, the substrate, the microwave resonator and the microwave source - may be common to several subsystems. A subsystem comprises a sensor head A and an excitation/readout/processing module B. In FIG. 4, only main functional modules are shown and a subsystem can comprise other modules (e.g. an analog-digital converter between the output of the lock-in amplifier and the processor).

According to one embodiment, the sensor head A comprises:

1. An NV diamond 41
According to an embodiment, this is an ultrapure diamond crystal doped with NV centers. The size of the diamond is for example $0.2 \times 0.2 \times 0.2$ mm3 to allow obtaining a good spatial resolution in the measurements of the magnetic field . Note that while in the present embodiment, the diamond crystal is cubic and is shown as cubic in the different figures, it can in principle have any appropriate shape and size.

2. An optical fiber associated with the NV diamond

3. A bias magnet 45
The magnetic bias may be provided by a permanent magnet for allowing to resolve the different magnetic resonances. A typical value of the bias field is around 30 mT, but this value is given purely as a non-limiting example. Other types of sources of a continuous magnetic field, such as a coil, may also be used.

4. A microwave resonator 44,
The resonator ensures a sufficiently strong coupling between the NV electronic spins and a microwave magnetic field provided by a microwave source 43 (see below). As a non-limiting example, microwave magnetic field amplitudes of a few $10^{-4}$T can typically be used.

5. As necessary, a substrate and /or mechanical components e.g. a housing for holding the diamond, the microwave resonator, the fiber and the magnet.

According to one embodiment, the excitation/readout/processing module B comprises:

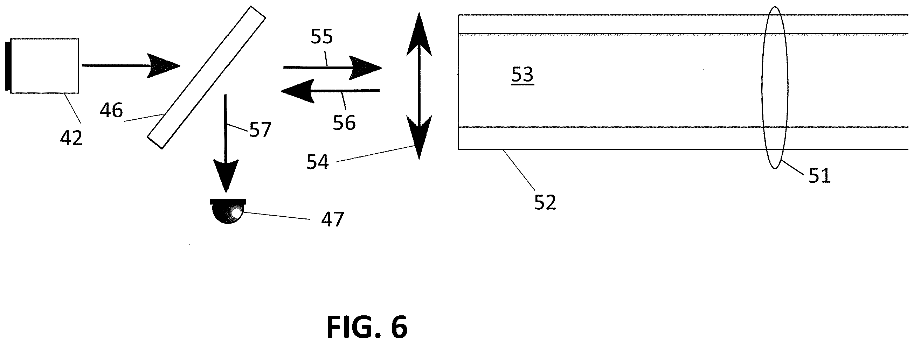

6. A green light source 42
This light source may be a laser or a LED, for example with a power in the range 1 - 100 mW at the wavelength in the range 510 - 550 nm and stabilized in power to ensure low enough relative intensity noise (RIN) level. Wavelength stabilization is not critical. The light from the source is injected into an optical fiber guiding the radiation to the diamond crystal 41 (see connection module 49, as well as FIG. 6 below). The optical fiber is maintained against the diamond by a micro-mechanical system and/or by glue.

7. A microwave source 43, the tunable frequency of which is around 2.87 GHz, coupled to microwave resonator 44. The microwave source is driven by a local oscillator 48c (also see lock-in amplifier below).

8. A green/red light separator 46
A green/red light separator 46 is used to separate the green light being injected into the optical fiber and the fluorescence emitted by the NV centers and having a wavelength at around 650 nm. The red fluorescence is re-emitted into the same fiber that also carries the green excitation light provided by source 42, hence the use of the separator, which can be a dichroic optical element or any optical system that can separate the green and red light.

9. A photodetector 47
In the present embodiment, the photodetector 47 is a photodiode, although other photodetectors may be used. The photodiode is used to detect the red light received as output from separator 46. The photodiode can be used in conjunction with a transimpedance amplifier (not shown) to generate a voltage based on the photodiode output and to feed the next stage.

10. A lock-in amplifier 48

The lock-in amplifier receives the signal from the photodiode 47 and its associated amplification means. The lock-in amplifier comprises a mixer 48a and a low-pass filter 48b. The mixer 48a is driven by local oscillator 48c, which according to one non-limiting embodiment is part of the lock-on amplifier. According to certain embodiments, the lock-in amplifier is a multiple input, multiple output amplifier, where each input receives the signal from a given photodiode, i.e. at least part of the lock-in amplifier is common to several submodules.

11. A processor 40

The processor may advantageously be located remotely compared to the sensor head A. It acquires and processes the information provided by the lock-in amplifier. It is also used to control a user interface for communication with the user. The processor executes software code stored in a memory (not shown). The processor is part of a control module which may comprise other components. According to certain embodiments, the processor processes signals provided by a plurality of photodiodes.

The sensor head A and the excitation/readout/processing module B are connected through a connection module 49, the role of which is to optically connect the modules A and B, either directly or through one or more appropriately placed connectors. A connector typically comprises a male and a female part which can be plugged together to achieve optical continuity of the fiber on the side of the male part on one hand and the fiber on the side of the female part on the other. In FIG. 4, the connection module is shown as partially part of sensor head A, partially part of excitation/readout/processing module B and partially external to any of these modules, but this representation is purely functional to illustrate that there may be, depending on the number of connections, an intermediate section which is not necessarily part of either the sensor head A or the excitation/readout/processing module B.

If an intermediate section of optical fiber is used, it is connected, through appropriate connectors, on one hand to the optical fiber optically connected to the NV doped diamond 41 and on the other hand to an optical fiber optically connected to separator 46. In such an embodiment, the intermediate section of optical fiber can be replaced as needed - this allows adjusting the maximum distance between the sensor head and the excitation/readout/processing module B e.g. as a function of a specific need or depending on a specific application. The sensor head and the excitation/readout/processing module then each comprise a respective length of optical fiber and a respective connector.

According to a variant embodiment, the connection module 49 comprises a continuous optical fiber that runs directly from the NV doped diamond 41 to the separator 46, i.e. there is no connector.

According to yet another embodiment, a single connector is provided in the connection module.

Providing connectors for the sensor head A and/or the excitation/readout/processing module makes these easily detachable and replaceable. Concerning the sensor head, a connector may advantageously be placed close to the sensor head, e.g. as a non-limiting example at a distance of several centimeter to several tenths of centimeters. Similarly, concerning the excitation/readout/processing module, a connector may also advantageously be placed close to the latter to allow replacement if defective or when different functionalities and or/processing are required.

According to an embodiment, the microwave source and the microwave resonator are connected through a cable e.g. running in parallel with the optical fiber. According to a variant embodiment, the connection module comprises one or more amplifiers for amplifying the microwave signal along the cable.

According to another embodiment, the microwave source produces microwaves that are optically transmitted and regenerated locally before being transmitted to the resonator.

According to an embodiment, the cable for connecting the microwave source and the microwave resonator may be part of the connection module, i.e. run along the optical fiber.

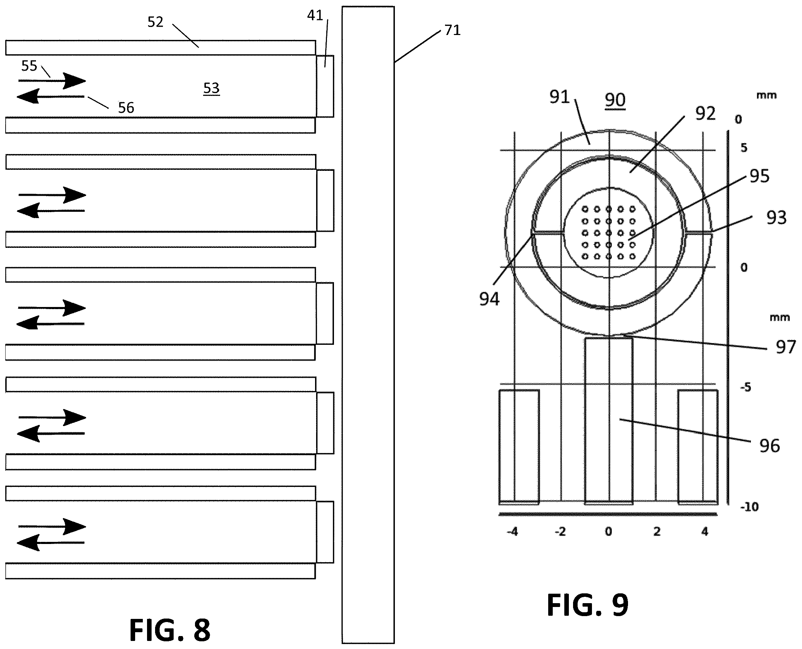

While the sensor head A and the excitation/readout/processing module B described in conjunction with FIG. 4 have been mainly described as containing components for a single pixel for clarity purposes, the sensor head A and excitation/readout/processing module B will typically contain components for a plurality of pixels, e.g. as described later in conjunction with FIG. 9 to FIG. 13 for sensor head A, with certain components common to several pixels. Considering the connection module 49 in this context, in a typical configuration, the sensor head A comprises as many lengths of optical fiber as there are NV diamond crystals (e.g. X), each length being associated with a respective diamond at one extremity (e.g. glued) and mechanically maintained by a first connector part by the other extremity to allow connection of this other extremity to another optical fiber through a second connector to be plugged into the first connector. Supposing no intermediate section is used, the excitation/readout/processing module B comprises the second connector adapted to mate with the first connector, the second connector maintaining X fibers for connecting with the X fibers of the first connector and which lead to X respective excitation/readout means.

In the embodiment in which the microwave source and the microwave resonator are connected through a cable, when several resonators need to be addressed individually, as many cables as there are microwave source and resonator pairs are provided through the connection module.

In the present embodiment, the measurement of the magnetic field is performed via the lock-in amplifier and is based on a frequency modulation (FM) spectroscopy technique. The microwave signal generated by microwave source 43 is frequency modulated. The frequency $f_{LO}$ used for this frequency modulation may for example be 100 KHz. This in turn modulates the level of red fluorescence around the minimum of the resonance curve at the same frequency. The signal output from the photodiode is therefore modulated at $f_{LO}$. The lock-in amplifier performs a synchronous detection by electronically mixing the signal coming from the photodiode with the local oscillator (LO) signal and by keeping only the slowly evolving part of the resulting signal, e.g. by applying low pass filter 48b. The resulting signal output from the lock-in amplifier is proportional to the derivative of the resonance and corresponds to a dispersive curve with a linear part that allows to translate the measured voltage into a frequency and therefore into a magnetic field value according to (see Eq.1 above).

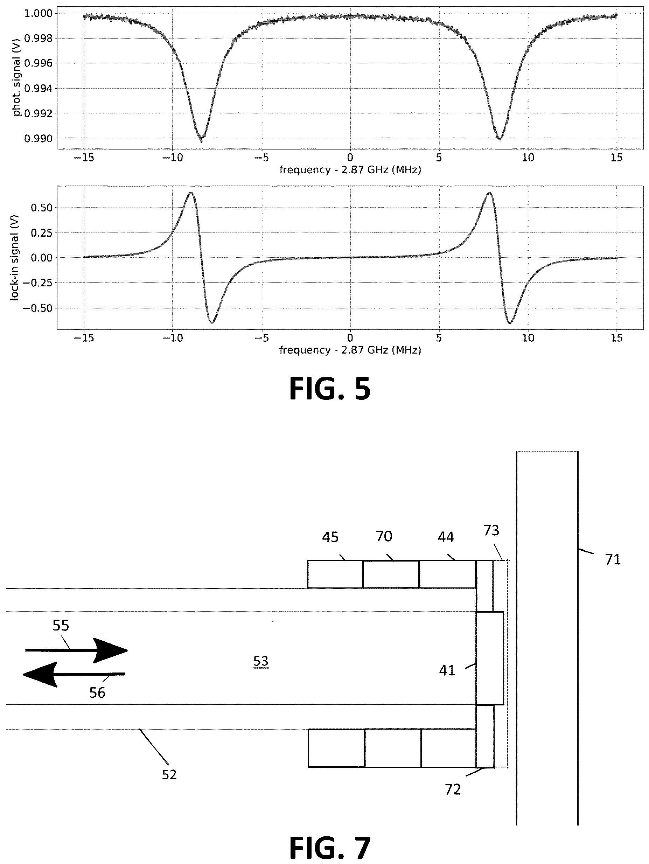

FIG. 5 shows the signal provided by the photodiode 47 as well as the demodulated signal provided by the lock-in amplifier 48. The graphs of FIG. 5 were obtained by sweeping the frequency of the microwave source, here over a range of 30 MHz around the central frequency of 2.87 GHz. The two resonances and resulting demodulation signals can be seen.

The NV magnetometer can be operated in two ways :

1) In open loop: the voltage from the demodulated photodiode signal is directly translated into the magnetic field value, which requires a calibration of the scale factor of the system (i.e. a calibration of the voltage to frequency/magnetic field conversion factor).

2) In closed loop: the dispersive signal is used in a servo loop where an actuating system is used to keep the demodulated signal close to 0 V with a controller (typically a PID). The actuator can be a feedback on the frequency of the microwave source or by applying a small additional magnetic field.

The ODMR optical resonance signal (see the upper graph in FIG. 5) is of the form:

$$S(\omega) = S_0\big(1 - C\mathcal{F}(\Delta\omega, \Gamma)\big)$$

where $S_0$ is the optical signal level (unit: W) out of resonance, C is the contrast of the resonance and $\mathcal{F}$ is the shape of the resonance (typically Lorentzian), as a function of the microwave detuning $\Delta\omega$ and the width of the resonance $\Gamma$.

The shot noise limited sensitivity of this measurement is:

$$\eta_{CW} = \mathcal{P}_F \frac{2\pi}{\gamma} \frac{\sqrt{2}\Delta\nu_{FWHM}}{C\sqrt{R}}$$

where $\mathcal{P}_F$ is a prefactor depending on the resonance shape ( $\mathcal{P}_F \approx 0.70$ for a Gaussian) and $\gamma = 2\pi \times 28$ *GHz. T*$^{-1}$ is the gyromagnetic ratio of the electron.

The width of the resonance curve can be estimated from the coherence time of the NV centers $\left(T_2^*\right)$ through the expression:

$$\Delta\nu_{FWHM} = \frac{1}{\pi T_2^*}$$

*R* is the photon count rate (unit: per second), corresponding to the fluorescence level far from the resonance. As NV sensors are usually operated far from optical saturation, the photon count rate can be obtained from:

$$R = \frac{\eta_{PD}S_0}{h\nu_{photon}} \approx \eta_{PL}\sigma ln \frac{\eta_{PD}P_{opt}}{h\nu_{photon}}$$

with $\eta_{PL}$ the fluorescence collection efficiency, $P_{opt}$ the optical power sent on the diamond, $\sigma$ the absorption cross section of NV centers ($3.1 \times 10^{-21}$ m$^2$), 1 the length of the NV doped layer, n the density of NV centers, $\eta_{PD}$ the quantum efficiency of the photodetector, related to its responsivity $\frac{\eta_{PD} e}{h\nu_{photon}} = A \; (\text{unit: A/W})$.

In practice, it is not easy to reach the laser shot noise level. The technical intensity noise of the source might generally be limiting. In this case, one can refer to its noise level using the Relative Intensity Noise (RIN), expressed as:

$$\text{RIN} = 20 \log_{10} \left( \frac{\sqrt{S_{power}}}{P_{opt}} \right) \; \left( \text{dB}/\sqrt{\text{Hz}} \right)$$

where $S_{power}$ is the spectral power density of the optical signal in W$^2$/Hz.

The red fluorescence signal, directly proportional to the green pumping laser, should present the same RIN level. In this case, the sensitivity becomes:

$$\eta_{CW} = \mathcal{P}_F \frac{2\pi}{\gamma} \frac{\Delta\nu}{C} 10^{(\text{RIN}/20)}$$

Typical values of NV centers characteristics and their associated noise levels are:

Table 1 : Parameters used for the estimation of the noise level of the magnetometer

| | |
|---|---|
| Contrast (%) | 0.5 |
| $T_2^*$ (ns) | 500 |
| $\eta_{collection}$ (%) | 1 |
| $l$ ($\mu$m) | 100 |
| n | $1.8 \times 10^{-23}$ $m^{-3}$ (concentration of 1 ppm of NV) |
| $\eta_{PD}$ | 0.67 |
| RIN $\left( \text{dB}/\sqrt{\text{Hz}} \right)$ | -120 |
| Photodetector conversion (V/W) | $4 \times 10^5$ |

As an example, the table below compares the impact of RIN and of the shot noise for an optical power of 10 mW (the RIN contribution to the noise being independent of the power level):

**Table 2** : Values for a typical use-case

| | |
|---|---|
| Green optical power (mW) | 10 |
| Fluorescence level (V) | 1.5 |
| Shot noise sensitivity $\left( \text{nT}/\sqrt{\text{Hz}} \right)$ | 1.3 |
| Technical noise (RIN) sensitivity $\left( \text{nT}/\sqrt{\text{Hz}} \right)$ | 3.5 |

In order to approach the optical shot noise limit, residual green excitation light should be suppressed from the measurement. In designs where the photodiode is placed close to the diamond, an important optical background of green light may impact sensor performance. This background may be due to green excitation light being reflected by the diamond, or scattered light, or even the photodetector directly seeing the source. To suppress this background, an optical filter is implemented, which absorbs the green light and is transparent to the red light going towards the detector.

In the fiber scheme proposed here, a high rejection of green light is facilitated owing to the remote nature of the green excitation and red fluorescence measurement. The separation between the green light and the red light is performed in a separate subsystem that can be placed far from the diamond, and where an optical element (e.g. a dichroic mirror) allows to best suppress any residual green excitation light.

As an example, in the scenario presented above, the red fluorescence power collected by the detector is about 3 $\mu$W (signal of 1.5 Volts) and the contrast is 0.5%, which means that the amplitude of the ODMR resonance amounts to 1.5 nW. This represents the useful signal, that is to be compared to the green light power of 10 mW used to excite the NV diamond. At least a millionfold rejection of the green light must therefore be obtained in order not to limit the sensitivity of the magnetometer. Such a high rejection is highly facilitated by the embodiments described herein, which are based on an optical fiber implementation of the NV diamond array sensor.

FIG. 6 is a schematic diagram that shows details of certain components of FIG. 4, including the optical fiber 51. The fiber 51 comprises a cladding 52 and a core 53. The green light source 42 illuminates the separator 46 so that the green light 55 traverses the separator and reaches a collimator 54, which is inserted between the separator 46 and the optical fiber, so that the green light may be efficiently coupled into the fiber core. The red fluorescence 56 emitted by the NV centers on the other hand travels from the fiber core 53 to separator 46 through collimator 54 and is reflected (as illustrated by arrow 57) by the separator towards photodetector 47.

FIG. 7 is a schematic diagram representing a side view of one extremity of the submodule corresponding to a single pixel of the array according to one embodiment. The diagram shows the optical fiber core 52 and cladding 53, with the NV diamond crystal 41 fixed to the extremity facing test sample 71. The extremity of the optical fiber may be fixed to the crystal 41 through any appropriate means, for example using glue. Crystal 41 is held by a substrate 72 (e.g. a printed circuit board (PCB)) through which an appropriate hole has been drilled. The crystal may be held in place with an appropriate substance like resin. The crystal may protrude from the surface of the substrate as shown. It may however also be flush with the substrate's surface or be recessed in order to improve protection. A layer of resin may additionally be applied to fill the recess, e.g. to protect the external surface of the sensor module destined to face the sample to be tested.

According to the embodiment shown in FIG. 7, both the microwave resonator 44 and bias magnet 45 are threaded on the optical fiber, with the microwave resonator being placed closest to the crystal 41. If a coil is used for generating the bias magnetic field instead of a permanent magnet, the coil can also be threaded on the optical fiber. The microwave resonator may also be simply printed on the substrate surface and may thus be much thinner than illustrated. While FIG. 7 shows the microwave resonator 44 placed on the side of the substrate on which the fiber arrives, i.e. the side not facing the test sample, it may also be placed on the side facing the sample, in particular if it is printed. Coming back to FIG. 7, a spacer 70 is optionally inserted between the microwave resonator and the bias magnet. In this embodiment, there is a specific microwave resonator for each crystal. In other embodiments, a microwave resonator may be common to several crystals, or a single microwave resonator may be used for all crystals. Using several microwave resonators allows addressing groups of crystals separately, or individual pixels individually. This enables individual pixel closed loop read-out with a broad dynamic scale. In the embodiment of FIG. 7, there is also an individual bias magnet threaded on each crystal. In other embodiments, a bias magnet may be common to several crystals, or a single bias magnet may be used for all crystals.

The embodiment of FIG. 7 allows the crystal to be placed close to the sample to be tested, since the resonator and bias magnet are positioned behind the crystal when seen from the point of view of the sample.

According to a variant embodiment, the surface of the substrate, including the diamond crystals, is covered with a protective coating, such as, but not limited to, resin. In FIG. 7, this coating is illustrated by line 73.

According to a variant embodiment, the substrate is made of the same material as the protective coating.

According to a variant embodiment, the microwave resonator is printed on the surface of the substrate, either on the surface which is to face the sample, or the opposite surface. When the microwave resonator is placed on the surface of the substrate which is to face the sample, the side of the diamond crystal to face the sample is at least flush with the resonator. Preferably, the side of the crystal to face the sample protrudes beyond the resonator to allow the diamond crystal to be closer to the sample.

Crystals flush with or protruding from the front of the sensor head, compared to any structure (such as but not limited to the resonator) or substance (such as but not limited to a protective coating) placed on the front side of the substrate, have the advantage of allowing the crystals to be placed closer to the sample compared to recessed crystals. The crystals can then be in contact with or at a very small distance from the sample, without any intermediate component or material other than the medium in which the sample is possibly immerged.

FIG. 8 is a schematic diagram representing a side view of five aligned submodules each corresponding to a single pixel of the array according to one embodiment. Compared to FIG. 7, the microwave resonator 44, the bias magnet 45, the spacer 70 and the substrate 72 are not shown.

While the figures and embodiments described herein use ring-based resonators, other resonator types may be used, with different structure and shape, e.g. square-shaped, using one perimeter or a plurality of concentric perimeters...

In non-limiting embodiments illustrated by FIG. 9 to FIG. 11, a single resonator is used to provide microwaves to all crystals of an array of a sensor.

FIG. 9 is a schematic diagram of a microwave resonator used for all crystals of an array, in this case a 5x5 array of crystals. The resonator comprises two concentric rings, an outer ring 91 and an inner ring 92, with each ring comprising a gap, respectively gap 93 for the outer ring and gap 94 for the inner ring, the array 95 of holes drilled for the crystals placed within the inner ring. This allows for a sufficiently homogeneous microwave field in the area of the array. As a non-limiting example, the holes have a diameter of 200 $\mu$m - however other dimensions can be used. A feed line 96 is provided, with a coupling gap 97 between the outer ring 91 and the extremity of the feed line 96. The feed line 96 is connected to the microwave source 43 (not shown in FIG. 9).

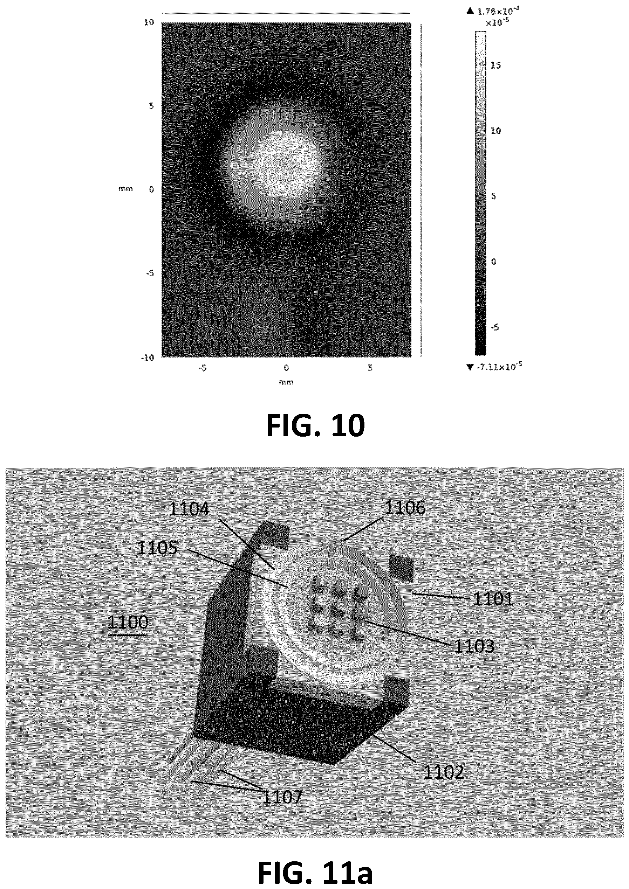

FIG. 10 represents a simulation of the microwave magnetic field (at the frequency of 2.87 GHz for the resonator shown in FIG. 9. The unit bar is labelled in Tesla. As can be seen, the magnetic field within the inner circle has an amplitude above 0,1 mT.

FIG. 11a is a three-dimensional rendering of a sensor device 1100 according to an embodiment. The sensor device comprises a substrate 1101 maintained by a protective housing 1102. The substrate comprises a three-by-three array 1103 of diamond crystals. Outer and inner resonator rings 1104 and 1105 are printed on the side of the substrate to face the sample or object to be tested. In the frame of the example of FIG. 11a, where a single resonator printed on one side of the substrate surrounds the array of crystals, the width and length e of the substrate is determined by the resonator. While the shape of the substrate is square in the shown example, it could also have the general shape of the resonator. The resonator comprises a line 1106 which reaches one side of the substrate. A feed (not shown) is arranged within the sensor and feeds the resonator through line 1106. The feed may be placed on the side of the substrate close to line 1006. In another embodiment, the resonator may also be fed by a feed placed in a hole drilled through the substrate. The feed is connected to a cable mentioned earlier that carries the signal from the microwave source in the excitation/readout/processing module. The individual optical fibers 1107 connected to respective crystals protrude at the back of the sensor housing 1102. While shown straight, the fibers may be bent to take another path, in particular when the fibers need to be deviated to provide space for a single bias magnet located in the back of the housing. The housing 1102 maintains the different components mechanically or these components are maintained in place using resin or glue.

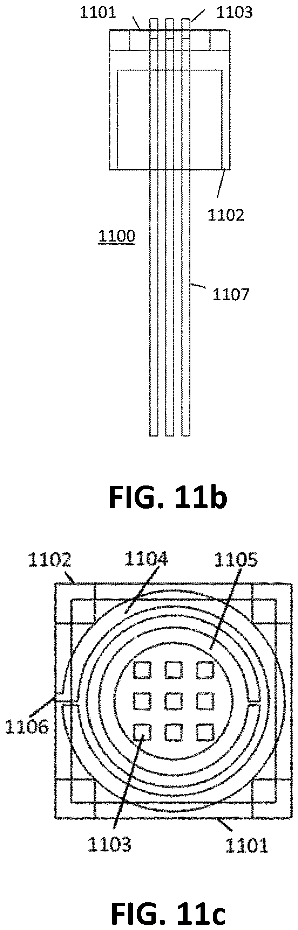

FIG. 11b is a sectional side view of the sensor head of FIG. 11a. In the embodiment illustrated by this figure, the protrusion of crystals 1103 compared to the surface or front side of the substrate 1101 is apparent.

FIG. 11c is a front view of the sensor head of FIG. 11c, noting that the outlines of the inner wall of housing 1102 are also shown in transparency.

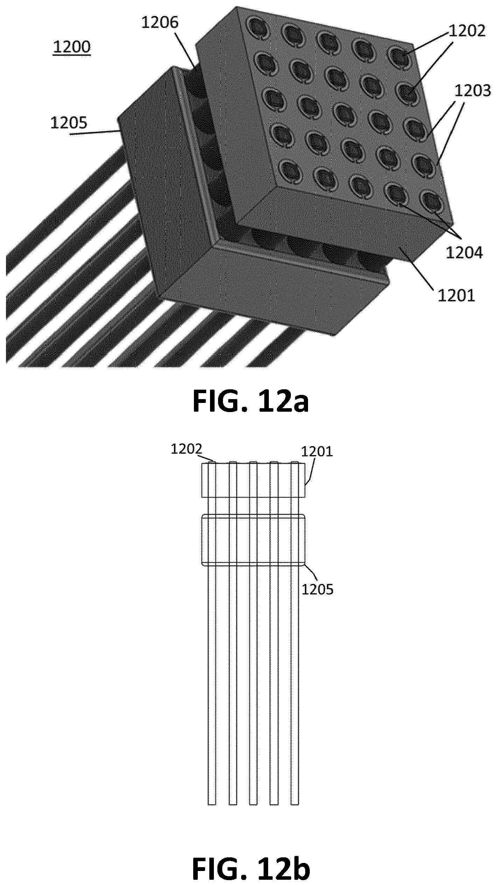

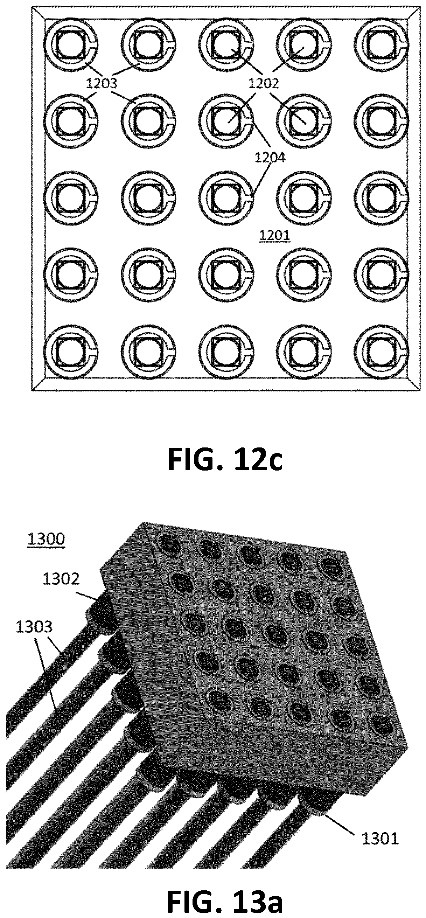

In non-limiting embodiments illustrated by FIG. 12a-c and FIG. 13a-b, each crystal of an array of a sensor is provided with a respective individual resonator.

FIG. 12a is a three-dimensional rendering of a sensor 1200 according to one embodiment, in which a single bias magnet is used to bias all NV diamond crystals. The sensor comprises a substrate 1201 holding an array of crystals 1201, which in the example illustrated is a five-by-five array. Each crystal 1202 is surrounded by a resonator 1203, which in the non-limiting case of FIG. 12a is a ring-shaped resonator. Each resonator ring is provided with a gap 1204 and is fed through the substrate by a conductor receiving a signal from a microwave source. Bias magnet 1205 has a square shape and comprises a series of holes with a pattern substantially the same as that of array 1201. The dimensions of the bias magnet are chosen to provide a sufficiently even bias magnetic field to all crystals. Each hole is such as to allow an individual fiber to pass through. A fiber may be fixed to the walls of a hole with an appropriate glue in order to provide further rigidity to the sensor. Optional spacers 1206 are provided between the magnet and the substrate. While spacers 1206 are shown as individual tube-shaped sections around each optical fiber, in a variant embodiment, a spacer plate with appropriate holes for passing the fibers through can be used instead.

FIG. 12b is a simplified sectional side view of the sensor module of FIG. 12a, where the spacers have been omitted. FIG. 12c is a front view of the sensor module of FIG. 12c, which shows the diamond crystals 1202 within the ring resonators 1203, as well as gaps 1204.

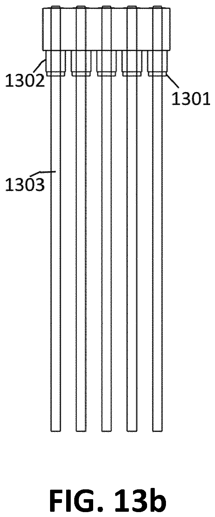

FIG. 13a is a three-dimensional rendering of a sensor 1300 according to one embodiment, in which individual bias magnets 1301 are used to bias each NV diamond crystal individually. Optional spacers 1302 and fibers 1303 are also shown. Other components of sensor 1300 are similar to those of sensor 1200. FIG. 13b is a simplified sectional side view of the sensor module of FIG. 13b, showing the individual magnets 1301, the spaces 1302 and the fibers 1303.

The embodiments described have in common that the microwave resonator or resonators on one hand and the photodiodes on the other can be implemented at a distance relative to each other, i.e. the photodiodes can be removed from the microwave resonator through at maximum the length of the optical fiber and other intervening components such as the separator. Implementing both the photodiode and the resonator closely together, e.g. such as on a same CMOS package, creates issues owing to eddy currents generated by the microwave source that couple to the photodiode circuitry. Microwave circuitry and fluorescence detection are thus decoupled: the microwave resonators are in close proximity to the NV diamonds, while the red fluorescence detection circuitry is placed at a safe distance at a remote readout unit by the optical fibers.

The possibility of individual addressing of each diamond of the array by green excitation light is another advantage. In this case, there is an individual green light source per diamond. Each source may for example comprise an individual laser. Each NV diamond of the array and thus each pixel can be initialized (excited) and read out through an independent optical fiber. Such a configuration guarantees a low crosstalk between the pixels since:

o Each diamond pixel is addressed by its own green excitation light brought by its dedicated optical fiber;
o The red fluorescence of each diamond is coupled into a dedicated optical fiber.

Low crosstalk between the different pixels is important in NDT applications where the signature of interest (e.g. change of material property) has to be well resolved by looking at the weak magnetic signal differences between adjacent pixels.

It is however possible, according to a variant embodiment, to use a single source of light (a laser or a powerful LED) to generate a beam that is divided into sub-beams for exciting respective NV diamond crystals. One advantage of such a configuration is that the relative intensity noise (RIN) is common to all individual sensors.

[0088] - Separating the red fluorescence signal emitted by the NV centers from the green excitation light is important to reach a low noise floor of the magnetometer. Placing the photodetectors (photodiodes) measuring the red fluorescence in close proximity to the diamond excited by the green light complicates the separation between green and red. Implementing a dichroic filter e.g. on a CMOS chip in case of close proximity of the photodiode and of the NV diamond crystal is possible but adds manufacturing complexity. In the described embodiments, the diamond pixels are operated remotely from the green light source and red fluorescence readout system, allowing the use of regular dichroic element such as the dichroic mirror mentioned previously, simplifying the separation between green and red.

- While an implementation of an NV diamond sensor in CMOS technology may be relevant to some applications, it is hardly applicable to NDT in harsh environments with high temperatures (above 125°C) that occur in downhole conditions or in nuclear power reactors. In the above embodiments, the sensor per se, as illustrated for example by FIG. 11, FIG. 12, and FIG. 13, comprises passive elements: the diamonds, the microwave resonators and the magnet used to lift the degeneracy between the spin states. This is less critical regarding the impact of high temperatures.

While the above embodiments rely on fluorescence in the red spectrum (650 nm wavelength), it happens that another light is also emitted by the NV centers, at 1042 nm wavelength. This light is associated with the transition via the singlet state and can be used instead of the red fluorescence.

While the figures described above show arrays in the form of matrices of aligned rows and columns, the term 'array' should not be limited to such embodiments. Indeed, according to some embodiments:

- distinct rows or distinct columns of an array may contain different numbers of diamond crystals; and/or
- diamond crystals of consecutive rows or columns are not necessarily aligned. For example, diamond crystals may be placed according to a quincunx pattern; and/or
- the spacing between diamond crystals may vary - in particular, it may be irregular. The goal of the sensor being to image the magnetic field with the best spatial resolution possible, depending on the spatial frequencies of interest in the magnetic field to image, an irregular sampling (e.g. with incommensurate spacing) can be advantageous. Nevertheless, a regular spacing may be advantageous from a manufacturing point of view.

The use of an array comprising a plurality of diamond crystals allows the direct imaging of an area of an item to be analyzed, contrary to single-crystal set-ups. As a non-limiting example, a 16 by 16 or a 256 by 256 diamond crystal array may be used to obtain an image that is sufficient to judge of the presence of defects in an area; without having to move the sensor head.

| Reference List | | | |
|---|---|---|---|
| 40 | Microprocessor | 93 | Outer ring gap |
| 41 | NV diamond crystal | 94 | Inner ring gap |
| 42 | Green light source | 95 | Hole array |
| 43 | Microwave source | 96 | Feed line |
| 44 | Microwave resonator | 97 | Coupling gap |
| 45 | Bias magnet | 1100 | Sensor |

(continued)

| | | | |
|---|---|---|---|
| 46 | Green/red light separator | 1101 | Substrate |
| 47 | Photodetector | 1102 | Housing |
| 48 | Lock-in amplifier | 1103 | Crystal array |
| 48a | Mixer | 1104 | Outer resonator ring |
| 48b | Low pass filter | 1105 | Inner resonator ring |
| 48c | Local oscillator | 1106 | Line |
| 49 | Connection module | 1107 | Optical fibers |
| 51 | Optical fiber | 1200 | Sensor |
| 52 | Fiber cladding | 1201 | Substrate |
| 53 | Fiber core | 1202 | NV diamond crystal |
| 54 | Fiber collimator | 1203 | Ring resonator |
| 55 | Green excitation light | 1204 | Resonator gap |
| 56 | NV fluorescence | 1205 | Bias magnet |
| 57 | Reflected NV fluorescence | 1206 | Spacer |
| 70 | Spacer | 1300 | Sensor |
| 71 | Test sample | 1301 | Bias magnet |
| 72 | Substrate | 1302 | Spacer |
| 91 | Resonator outer ring | 1303 | Optical fiber |
| 92 | Resonator inner ring | | |

**Claims**

1. A sensor head (A) comprising:

   an array of a plurality of point defect doped diamond crystals (1103, 1202);
   a plurality of optical fibers (52, 1107), a first end of each fiber being optically coupled to a respective crystal (41);
   at least one magnet (45, 1205, 1301) for providing a bias magnetic field to the crystals;
   at least one resonator (44) for providing a microwave magnetic field to said crystals;
   a substrate (1101, 1201) having a front side for facing an item (71) to be analyzed using said array and a back side opposite to the front side;
   a second end of each fiber being adapted to receive excitation light (42) for exciting the respective crystal and to transmit a fluorescence light generated by the respective crystal (41);
   wherein said array of crystals is positioned with regard to said substrate to be able to face said item, each optical fiber being positioned to illuminate the respective crystal from the back side of the substrate towards the front side.

2. The sensor head according to claim 1, wherein each of said crystals (41) protrudes from said front side of the substrate.

3. The sensor head according to one of the claims 1 or 2, wherein said at least one resonator is a flat resonator (90, 1104, 1105, 1203), printed on said front side of the substrate or the back side of the substrate.

4. The sensor head according to one of the claims 1 to 3, comprising a single common resonator (1104, 1105) for providing a microwave magnetic field to all diamond crystals of the plurality of diamond crystals.

5. The sensor head according to claim 4, wherein said single common resonator (1104, 1105) is a ring resonator, said array (1103) of diamond crystals being placed within the perimeter of a ring (1105) of the ring resonator.

6. The sensor head according to one of the claims 4 or 5, further comprising an electric conductor adapted to provide a microwave signal from a microwave source (43) to said resonator (44).

7. The sensor head according to one of the claims 1 to 3, comprising a respective individual resonator (1203) for each crystal (1202) of the array.

8. The sensor head according to claim 7, wherein said respective resonator is a ring resonator, wherein a crystal is placed within a ring of its respective resonator.

9. The sensor head according to one of the claims 7 or 8, further comprising a respective electric conductor adapted to provide a microwave signal from a respective microwave source to a respective individual resonator.

10. The sensor head according to one of the claims 1 to 9, wherein said diamond crystals and said substrate are covered with a protective coating (73) to achieve a flat sensor head surface on said front side.

11. The sensor head according to one of the claims 1 to 7, wherein said at least one magnet comprises one of:

- an individual permanent magnet (45) for each crystal (41) in the array, wherein each individual magnet is threaded on an optical fiber coupled to its respective crystal; or
- an individual coil each crystal (41) in the array, wherein each individual coil is threaded on an optical fiber coupled to its respective crystal.

12. The sensor head according to one of the claims 1 to 7, wherein said at least one magnet comprises as single permanent magnet for all crystals in the array, wherein said single magnet is drilled with a plurality of respective holes, each hole being configured to let one fiber pass.

13. The sensor head according to one of the claims 1 to 12, wherein said point defect is one of a Nitrogen Vacancy, NV, a Silicon Vacancy, SiV, or Germanium Vacancy, GeV, point defect.

14. A measuring device (B) comprising a sensor head according to one of the claims 1 to 13, further comprising:

- at least one microwave source (43) for providing a respective microwave signal to each of said at least one resonators (44);
- at least one source of excitation light (42) for providing a respective excitation light to each diamond crystal (41) through a respective fiber (51);
- a respective photodiode (47) for each of said plurality of diamond crystals, a respective photodiode being optically coupled to receive, by a separator (46) adapted to filter out excitation light, a fluorescence generated by a respective diamond crystal through a respective optical fiber (51), and for generating a respective signal in response to said fluorescence;
- at least one amplifier (48) for amplifying respective signals from said photodiodes for providing respective amplified signals;
- a processor (40) for processing said respective amplified signals provided by said amplifier and for generating a signal representative of an image representative of an item being analyzed by said sensor head.

15. A measuring device according to claim 14, wherein, when said sensor head (A) comprises an individual resonator (1203) for each diamond crystal, the measuring device comprises a respective individually controllable microwave source for each individual resonator.

**FIG. 1**

**FIG. 2**

**FIG. 3**

**FIG. 4**

**FIG. 5**

**FIG. 7**

FIG. 6

**FIG. 8**

**FIG. 9**

EP 4 119 938 A1

FIG. 10

FIG. 11a

**FIG. 11b**

**FIG. 11c**

FIG. 12a

FIG. 12b

**FIG. 12c**

**FIG. 13a**

FIG. 13b

Europäisches
Patentamt

European
Patent Office

Office européen
des brevets

# EUROPEAN SEARCH REPORT

Application Number

**EP 21 30 5970**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 083 364 A (AOIWAY ELECTRONIC TECH NANJING CO LTD) 15 December 2020 (2020-12-15) * figures 1,2 * | 1-9, 11-15 | INV. G01N27/82 G01N27/83 G01R33/26 |
| X | KUWAHATA AKIHIRO ET AL: "Magnetometer with nitrogen-vacancy center in a bulk diamond for detecting magnetic nanoparticles in biomedical applications", SCIENTIFIC REPORTS, [Online] vol. 10, no. 1, 1 December 2020 (2020-12-01), page 2483, XP055907958, DOI: 10.1038/s41598-020-59064-6 INTERNET Retrieved from the Internet: URL:https://www.nature.com/articles/s41598 -020-59064-6.pdf> [retrieved on 2022-04-01] * the whole document * | 1,3-10 | |
| A | US 2018/275210 A1 (LUZOD NICHOLAS M [US]) 27 September 2018 (2018-09-27) * the whole document * | 1-15 | TECHNICAL FIELDS SEARCHED (IPC) G01N G01R |
| A | DE 10 2019 212587 A1 (BOSCH GMBH ROBERT [DE]) 25 February 2021 (2021-02-25) * figure 8 * | 1-15 | |

The present search report has been drawn up for all claims

| Place of search | Date of completion of the search | Examiner |
|---|---|---|
| Munich | 6 April 2022 | Schindler, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 30 5970

This annex lists the patent family members relating to the patent documents cited in the above-mentioned European search report.
The members are as contained in the European Patent Office EDP file on
The European Patent Office is in no way liable for these particulars which are merely given for the purpose of information.

06-04-2022

| Patent document cited in search report | | Publication date | Patent family member(s) | Publication date |
|---|---|---|---|---|
| CN 112083364 | A | 15-12-2020 | NONE | |
| US 2018275210 | A1 | 27-09-2018 | NONE | |
| DE 102019212587 | A1 | 25-02-2021 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10962610 B

**Non-patent literature cited in the description**

- **HATANO et al.** Applied Physics Letter. AIP Publishing, 2021, vol. 118, 034001

- Imaging Damage in Steel Using A Diamond Magnetometer. **L.Q. ZHOU et al.** Physical Review Applied. American Physical Society, 2021, vol. 15, 024015